# EUROPEAN PATENT APPLICATION

(11) **EP 4 661 616 A2**
(43) Date of publication of application: **10.12.2025**
(21) Application number: 25168544.2
(22) Date of filing: 04.04.2025
(51) Int. Cl.: H10B 51/10, H10B 51/20, H10B 51/30, H10D 64/68, H10D 64/01

(54) **INTEGRATED CIRCUIT DEVICES HAVING VERTICALLY EXTENDING GATE LINES WITH WRAP- AROUND CHANNEL LAYERS**

(30) Priority: 03.06.2024 KR 20240072647
(71) Applicant: Samsung Electronics Co., Ltd., Suwon-si, Gyeonggi-do 16677 (KR)
(72) Inventor: YANG, Seryeun, 16677 Suwon-si (KR); GOH, Youngin, 16677 Suwon-si (KR); LEE, Jeonil, 16677 Suwon-si (KR); LEE, Seoha, 16677 Suwon-si (KR); HA, Daewon, 16677 Suwon-si (KR)
(74) Representative: Marks & Clerk LLP

(57) **Abstract**

An integrated circuit device includes a gate line extending in a first direction, which is generally normal to a surface of an underlying substrate, and a dielectric layer at least partially surrounding a sidewall of the gate line. A metal layer is provided, which at least partially surrounds the sidewall of the gate line, and a fixed charge layer is provided, which at least partially surrounds the sidewall of the gate line. A gate dielectric layer is provided, which at least partially surrounds the sidewall of the gate line, and a ring-shaped channel layer is provided on the gate dielectric layer.

## Description

### BACKGROUND

The inventive concept relates to integrated circuit devices and, more particularly, to integrated circuit devices including memory devices arranged in three dimensions.

With the demand for compact and multi-functionalized high-performance electronic products, high-capacity semiconductor memory devices are required. To provide high-capacity semiconductor memory devices, there is demand for an increase in integration density. Because the integration density of two-dimensional (2D) semiconductor memory devices according to the related art mainly depends on an area occupied by a memory cell, the integration density of 2D semiconductor memory devices is nonetheless limited. Therefore, integrated circuit devices including three-dimensional (3D) semiconductor memory devices, which increase memory capacity by stacking a plurality of memory cells on a substrate in a vertical direction, have been suggested.

### SUMMARY

The inventive concept provides an integrated circuit device having increased durability and performance.

According to an aspect of the inventive concept, there is provided an integrated circuit device including a gate line extending in a vertical direction on a substrate, a dielectric layer surrounding the gate line and extending in the vertical direction, at least one metal layer surrounding the gate line, at least one fixed charge layer surrounding the gate line, and at least one gate dielectric layer surrounding the gate line.

According to another aspect of the inventive concept, there is provided an integrated circuit device including a gate line extending in a vertical direction on a substrate, a dielectric layer surrounding the gate line and extending in the vertical direction, a fixed charge layer surrounding the gate line and extending in the vertical direction, and a gate dielectric layer surrounding the gate line and extending in the vertical direction, wherein the dielectric layer includes an antiferroelectric material.

According to a further aspect of the inventive concept, there is provided an integrated circuit device including a gate line extending in a vertical direction on a substrate, an adhesive layer surrounding the gate line and extending in the vertical direction along an outer sidewall of the gate line, a dielectric layer surrounding the gate line and extending in the vertical direction along an outer sidewall of the adhesive layer, a plurality of metal layers in contact with an outer sidewall of the dielectric layer, the plurality of metal layers surrounding the gate line and spaced apart from each other in the vertical direction, a plurality of fixed charge layers in contact with the plurality of metal layers, respectively, the plurality of fixed charge layers surrounding the gate line and spaced apart from each other in the vertical direction, and a plurality of gate dielectric layers in contact with the plurality of fixed charge layers, respectively, the plurality of gate dielectric layers surrounding the gate line and spaced apart from each other in the vertical direction.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a cross-sectional view of an integrated circuit device according to embodiments;
FIG. 2 is a plan view taken along line A1-A1' in FIG. 1;
FIG. 3 is a plan view illustrating a partial configuration of an integrated circuit device, taken along a line corresponding to line A1-A1' in FIG. 1, according to embodiments;
FIG. 4 is a plan view illustrating a partial configuration of an integrated circuit device, taken along a line corresponding to line A1-A1' in FIG. 1, according to embodiments;
FIG. 5 is a plan view illustrating a partial configuration of an integrated circuit device, taken along a line corresponding to line A1-A1' in FIG. 1, according to embodiments;
FIG. 6 is a plan view illustrating a partial configuration of an integrated circuit device, taken along a line corresponding to line A1-A1' in FIG. 1, according to embodiments;
FIG. 7 is a plan view illustrating a partial configuration of an integrated circuit device, taken along a line corresponding to line A1-A1' in FIG. 1, according to embodiments;
FIG. 8 is a cross-sectional view of an integrated circuit device according to embodiments;
FIG. 9 is a plan view taken along line A2-A2' in FIG. 8;
FIG. 10 is a plan view illustrating a partial configuration of an integrated circuit device, taken along a line corresponding to line A2-A2' in FIG. 8, according to embodiments; and
FIGS. 11 to 24 are cross-sectional views illustrating a method of manufacturing an integrated circuit device, according to embodiments.

### DETAILED DESCRIPTION OF EMBODIMENTS

Hereinafter, embodiments of the inventive concept are described in detail with reference to the accompanying drawings. In the drawings, like reference characters denote like elements, and redundant descriptions thereof will be omitted.

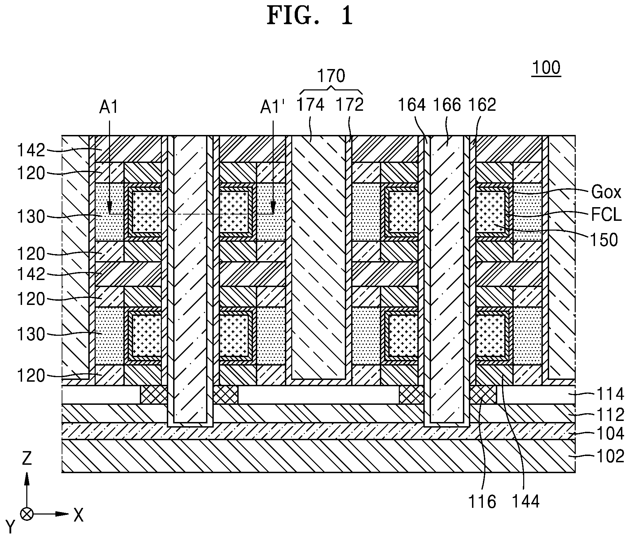

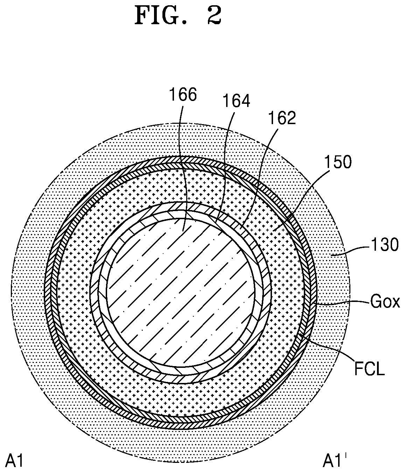

FIG. 1 is a cross-sectional view of an integrated circuit device 100 according to embodiments. FIG. 2 is a plan view taken along line A1-A1' in FIG. 1. Referring to FIGS. 1 and 2, the integrated circuit device 100 may include a substrate 102, a global gate line 104 on the substrate 102, a plurality of gate lines 166 connected to the global gate line 104, and a plurality of channel layers 130 each surrounding one of the gate lines 166.

The substrate 102 may include a semiconductor material, such as a Group IV semiconductor, a Group III-V compound semiconductor, or a Group II-VI oxide semiconductor. For example, the Group IV semiconductor may include silicon (Si), germanium (Ge), or silicon germanium (SiGe). The substrate 102 may be provided as a bulk wafer or an epitaxial layer. In an embodiment, the substrate 102 may include a silicon-on-insulator (SOI) substrate or a germanium-on-insulator (GeOl) substrate.

Although not shown in FIGS. 1 and 2, a peripheral circuit and a wiring layer connected to the peripheral circuit may be further formed in a portion of the substrate 102. For example, the peripheral circuit may include a planar metal-oxide semiconductor field-effect transistor (MOSFET), which forms a sub word line driver, a sense amplifier, or the like. Although not shown in FIGS. 1 and 2, a lower insulating layer may be further formed on the substrate 102 to cover the peripheral circuit and the wiring layer.

The global gate line 104 may be disposed on the substrate 102. A first insulating layer 112 may be disposed on the global gate line 104. An etch stop film 116 may be disposed on the first insulating layer 112. The etch stop film 116 may be surrounded by a second insulating layer 114. For example, the global gate line 104 may include at least one selected from the group consisting of a doped semiconductor material, conductive metal nitride, metal, and a metal-semiconductor compound. For example, each of the first insulating layer 112 and the second insulating layer 114 may include nitride, oxide, or a combination thereof. For example, the etch stop film 116 may include silicon carbide (SiC), silicon nitride (SiN), nitrogen-doped silicon carbide (SiC:N), SiOC, AIN, AlON, AlO, AlOC, or a combination thereof.

Each of the gate lines 166 may extend lengthwise on the substrate 102 in a vertical direction (a Z direction) that is generally normal to an upper surface of the substrate 102. The gate lines 166 may be spaced apart from each other in a first horizontal direction (an X direction) and a second horizontal direction (a Y direction) on the substrate 102. Each of the gate lines 166 may pass through the etch stop film 116 and the first insulating layer 112 and extend into the global gate line 104. According to some embodiments, each of the "vertical" gate lines 166 may include at least one material selected from the group consisting of a doped semiconductor material, conductive metal nitride, metal, and a metal-semiconductor compound.

An adhesive layer 164 may surround the sidewall and bottom surface of each of the gate lines 166. The adhesive layer 164 may pass through the etch stop film 116 and the first insulating layer 112 and extend into the global gate line 104. A lower end portion of the adhesive layer 164 may be in contact with the etch stop film 116, the first insulating layer 112, and the global gate line 104. For example, the adhesive layer 164 may include TiN, TaN, or a combination thereof.

A dielectric layer 162 may surround at least a portion of the sidewall of the adhesive layer 164. The bottom surface of the dielectric layer 162 may be in contact with the top surface of the etch stop film 116. The bottom surface of the dielectric layer 162 may be at a higher vertical level than the bottom surface of the adhesive layer 164. In embodiments, the dielectric layer 162 may include an antiferroelectric material. For example, the antiferroelectric material may include at least one selected from the group consisting of hafnium, zirconium, silicon, yttrium, aluminum, gadolinium, strontium, lanthanum, titanium, scandium, and oxides thereof.

In some alternative embodiments, the dielectric layer 162 may include a ferroelectric material. For example, the ferroelectric material may include at least one selected from the group consisting of hafnium, zirconium, silicon, yttrium, aluminum, gadolinium, strontium, lanthanum, titanium, scandium, and oxides thereof. In some embodiments, an antiferroelectric material and a ferroelectric material may be the same material but may have different phases to thereby provide different electrical characteristics, etc. For example, hafnium oxide in a tetragonal phase may correspond to an antiferroelectric material, however, hafnium oxide in an orthorhombic phase may correspond to a ferroelectric material.

Each of the channel layers 130 may surround one of the gate lines 166. Channel layers 130 surrounding one gate line 166 may be spaced apart from and overlap each other in the vertical direction (the Z direction). In embodiments, each of the channel layers 130 may have a ring shape surrounding one of the gate lines 166, according to a plan view. Each of the channel layers 130 may include a source/drain region (not shown). For example, the source/drain region may include an impurity-doped semiconductor material.

In some embodiments, each of the channel layers 130 may include polysilicon. In some embodiments, each of the channel layers 130 may include amorphous metal oxide, polycrystalline metal oxide, or a combination thereof. For example, each of the channel layers 130 may include at least one selected from the group consisting of In-Ga-based oxide (IGO), In-Zn-based oxide (IZO), and In-Ga-Zn-based oxide (IGZO).

A metal layer 150, a fixed charge layer FCL, and a gate dielectric layer Gox may be between a gate line 166 and a channel layer 130 surrounding the gate line 166.

The metal layer 150 may surround the gate line 166 and at least a portion of the sidewall of the dielectric layer 162. One gate line 166 may be surrounded by a plurality of metal layers 150. The metal layers 150 surrounding one gate line 166 may be spaced apart from each other in the vertical direction (the Z direction). For example, each of the metal layers 150 may include at least one selected from the group consisting of a doped semiconductor material, conductive metal nitride, metal, and a metal-semiconductor compound.

The fixed charge layer FCL may surround the gate line 166 and the outer sidewall, top surface, and bottom surface of a metal layer 150. One gate line 166 may be surrounded by a plurality of fixed charge layers FCL. The fixed charge layers FCL surrounding one gate line 166 may be spaced apart from each other in the vertical direction (the Z direction). For example, each of the fixed charge layers FCL may include aluminum oxide, hafnium oxide, tantalum oxide, titanium oxide, silicon nitride, or a combination thereof.

In embodiments, each fixed charge layer FCL may have a positive or negative charge density. In embodiments, the fixed charge layer FCL may be doped with dopant particles. For example, the dopant particles may include at least one selected from the group consisting of Al, P, Ca, Sc, V, Cr, Sr, Y, Nb, Mo, Tm, Yb, Lu, Ta, and W. In some embodiments, the fixed charge layer FCL may have oxygen vacancies therein. Moreover, a hysteresis curve of the dielectric layer 162 including an antiferroelectric material may shift to the left or the right on a voltage axis due to the presence of the fixed charge layer FCL, which has the positive or negative charge density. As the hysteresis curve of the dielectric layer 162 including an antiferroelectric material shifts to the left or the right on the voltage axis, the dielectric layer 162 including the antiferroelectric material may have a non-zero polarization value even at a voltage of 0. Accordingly, the dielectric layer 162 including an antiferroelectric material may operate in the same manner as the dielectric layer 162 including a ferroelectric material having a non-zero polarization value even at a voltage of 0.

The gate dielectric layer Gox may surround the gate line 166 and the outer sidewall, top surface, and bottom surface of the fixed charge layer FCL. One gate line 166 may be surrounded by a plurality of gate dielectric layers Gox. The gate dielectric layers Gox surrounding one gate line 166 may be spaced apart from each other in the vertical direction (the Z direction). For example, the gate dielectric layers Gox may include silicon oxide, silicon nitride, silicon oxynitride, or a combination thereof. In some embodiments, the gate dielectric layers Gox each may include a high-k dielectric material, which may be relative to silicon oxide. The high-k dielectric material may have a dielectric constant of about 10 to about 25. For example, the high-k dielectric material may include, but not limited to, hafnium oxide, aluminum oxide, zirconium oxide, or a combination thereof.

Conductive layers 120 may be separated from each other by a channel layer 130 in the vertical direction (the Z direction). The conductive layers 120 may be in contact with the top and bottom surfaces, respectively, of the channel layer 130. For example, the conductive layers 120 may include a source/drain contact, and each of the conductive layers 120 may include at least one material selected from the group consisting of a doped semiconductor material, conductive metal nitride, metal, and a metal-semiconductor compound.

An interlayer insulating layer 142 may be between an intercell insulating structure 170 and a gate line 166 adjacent to the intercell insulating structure 170 in the first horizontal direction (the X direction). The top and bottom surfaces of the interlayer insulating layer 142 may each be in contact with a conductive layer 120 and a buried insulating layer 144. A sidewall of the interlayer insulating layer 142 may be in contact with the dielectric layer 162 and an opposite sidewall of the interlayer insulating layer 142 may be in contact with the intercell insulating structure 170. For example, the interlayer insulating layer 142 may include silicon oxide, silicon nitride, or a combination thereof.

The buried insulating layer 144 may be between the conductive layer 120 and the gate lines 166. The top surface of the buried insulating layer 144 may be in contact with the interlayer insulating layer 142. The bottom surface of the buried insulating layer 144 may be in contact with the gate dielectric layer Gox. A sidewall of the buried insulating layer 144 may be in contact with the dielectric layer 162 and an opposite sidewall of the buried insulating layer 144 may be in contact with the conductive layer 120. For example, the buried insulating layer 144 may include silicon oxide, silicon nitride, or a combination thereof.

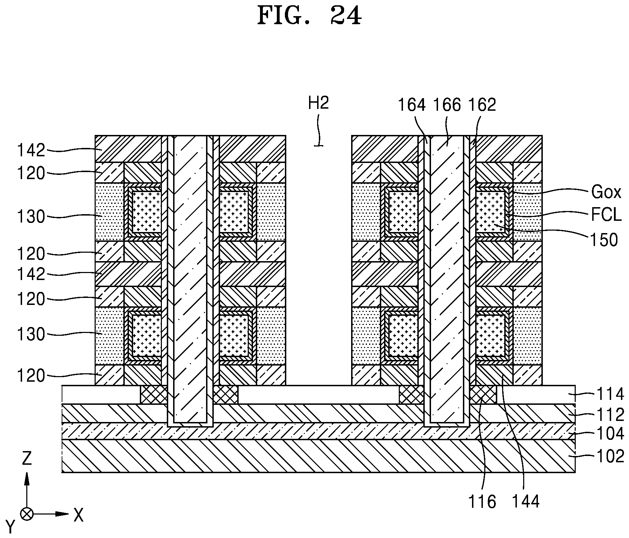

The intercell insulating structure 170 may be between gate lines 166 adjacent to each other in the first horizontal direction (the X direction). The intercell insulating structure 170 may extend in the vertical direction (the Z direction) through the interlayer insulating layer 142, the conductive layer 120, and the channel layer 130. The intercell insulating structure 170 may include an insulating liner 172, which covers the inner wall and bottom surface of a second hole H2 (in FIG. 24), and an intercell insulating film 174, which fills the second hole H2.

According to embodiments, the integrated circuit device 100 may include the dielectric layer 162 including an antiferroelectric material and the fixed charge layer FCL surrounding the dielectric layer 162. Because the dielectric layer 162 includes an antiferroelectric material, the integrated circuit device 100 may be driven with relatively low power, compared to a case where the dielectric layer 162 includes a ferroelectric material. Because a relatively low voltage is applied to the gate dielectric layer Gox when the integrated circuit device 100 operates, the durability of the gate dielectric layer Gox may be increased.

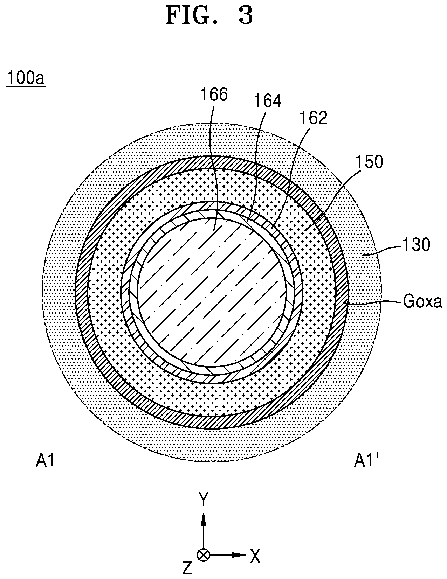

FIG. 3 is a plan view illustrating a partial configuration of an integrated circuit device 100a, taken along a line corresponding to line A1-A1' in FIG. 1, according to embodiments. The elements of the integrated circuit device 100a of FIG. 3 are similar to those of the integrated circuit device 100 described with reference to FIGS. 1 and 2, and thus, the differences between the integrated circuit devices 100a and 100 are mainly described below. Referring to FIG. 3, the integrated circuit device 100a may have a configuration substantially similar to the configuration of the integrated circuit device 100 of FIGS. 1 and 2, except that the integrated circuit device 100a does not include the fixed charge layer FCL (see FIG. 2). Because the integrated circuit device 100a does not include the fixed charge layer FCL (see FIG. 2), a gate dielectric layer Goxa may surround the outer sidewall, top surface, and bottom surface of the metal layer 150. The inner sidewall of the gate dielectric layer Goxa may be in contact with the metal layer 150. The outer sidewall of the gate dielectric layer Goxa may be in contact with the channel layer 130.

In embodiments, the thickness of the gate dielectric layer Goxa in a horizontal direction may be greater than the thickness of the gate dielectric layer Gox of the integrated circuit device 100 of FIGS. 1 and 2 in the horizontal direction. However, the inventive concept is not limited thereto. For example, the gate dielectric layer Goxa may include aluminum oxide, hafnium oxide, tantalum oxide, titanium oxide, silicon nitride, or a combination thereof. In other words, the material of the gate dielectric layer Goxa of the integrated circuit device 100a may be substantially the same as the material of the fixed charge layer FCL of the integrated circuit device 100 of FIGS. 1 and 2.

When the dielectric layer 162 includes an antiferroelectric material, the gate dielectric layer Goxa of the integrated circuit device 100a of FIG. 3 may move the hysteresis curve of the antiferroelectric material of the dielectric layer 162 to the left or the right on the voltage axis. In other words, the gate dielectric layer Goxa of the integrated circuit device 100a of FIG. 3 may perform the same function as the fixed charge layer FCL of the integrated circuit device 100 of FIGS. 1 and 2.

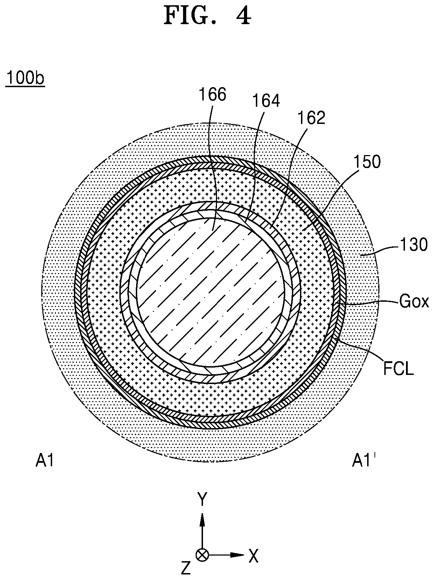

FIG. 3 is a plan view illustrating a partial configuration of an integrated circuit device 100b, taken along a line corresponding to line A1-A1' in FIG. 1, according to embodiments. The elements of the integrated circuit device 100b of FIG. 4 are similar to those of the integrated circuit device 100 described with reference to FIGS. 1 and 2, and thus, the differences between the integrated circuit devices 100b and 100 are mainly described below.

Referring to FIG. 4, the integrated circuit device 100b may have a configuration substantially similar to the configuration of the integrated circuit device 100 of FIGS. 1 and 2, except that the gate dielectric layer Gox is between the metal layer 150 and the fixed charge layer FCL. In this case, the inner sidewall of the gate dielectric layer Gox may be in contact with the outer sidewall of the metal layer 150. The outer sidewall of the gate dielectric layer Gox may be in contact with the inner sidewall of the fixed charge layer FCL. The outer sidewall of the fixed charge layer FCL may be in contact with the inner sidewall of the channel layer 130.

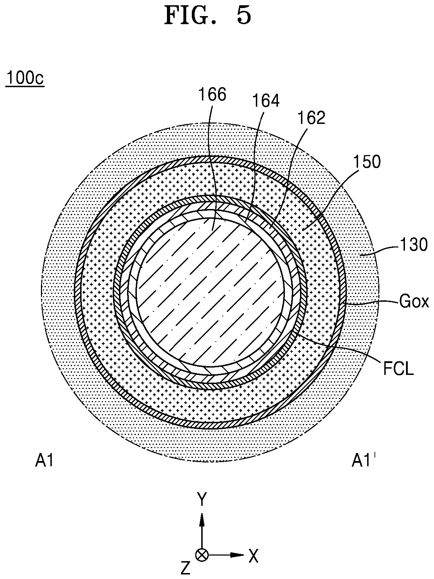

FIG. 5 is a plan view illustrating a partial configuration of an integrated circuit device 100c, taken along a line corresponding to line A1-A1' in FIG. 1, according to embodiments. The elements of the integrated circuit device 100c of FIG. 5 are similar to those of the integrated circuit device 100 described with reference to FIGS. 1 and 2, and thus, the differences between the integrated circuit devices 100c and 100 are mainly described below.

Referring to FIG. 5, the integrated circuit device 100c may have a configuration substantially similar to the configuration of the integrated circuit device 100 of FIGS. 1 and 2, except that the fixed charge layer FCL is between the metal layer 150 and the dielectric layer 162. In this case, the outer sidewall of the fixed charge layer FCL may be in contact with the inner side wall of the metal layer 150. The inner sidewall of the fixed charge layer FCL may be in contact with the outer sidewall of the dielectric layer 162. The outer sidewall of the gate dielectric layer Gox may be in contact with the inner sidewall of the channel layer 130.

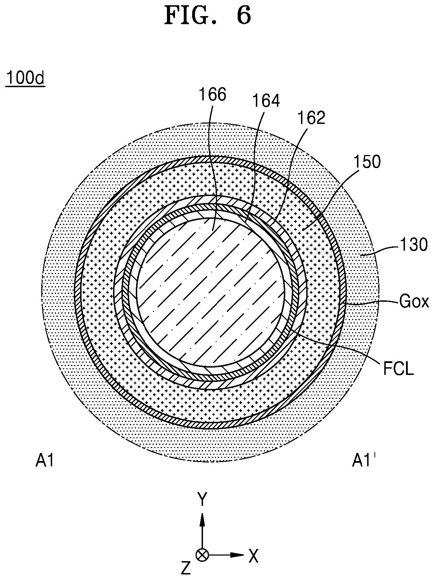

FIG. 6 is a plan view illustrating a partial configuration of an integrated circuit device 100d, taken along a line corresponding to line A1-A1' in FIG. 1, according to embodiments. The elements of the integrated circuit device 100d of FIG. 6 are similar to those of the integrated circuit device 100 described with reference to FIGS. 1 and 2, and thus, the differences between the integrated circuit devices 100d and 100 are mainly described below.

Referring to FIG. 6, the integrated circuit device 100d may have a configuration substantially similar to the configuration of the integrated circuit device 100 of FIGS. 1 and 2, except that the fixed charge layer FCL is between the dielectric layer 162 and the adhesive layer 164. The outer sidewall of the fixed charge layer FCL may be in contact with the inner side wall of the dielectric layer 162. The inner sidewall of the fixed charge layer FCL may be in contact with the outer sidewall of the adhesive layer 164.

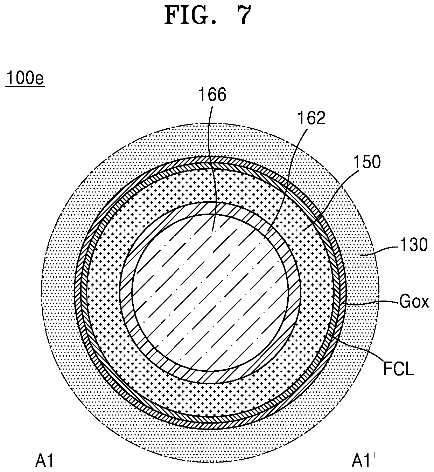

FIG. 7 is a plan view illustrating a partial configuration of an integrated circuit device 100e, taken along a line corresponding to line A1-A1' in FIG. 1, according to embodiments. The elements of the integrated circuit device 100e of FIG. 7 are similar to those of the integrated circuit device 100 described with reference to FIGS. 1 and 2, and thus, the differences between the integrated circuit devices 100e and 100 are mainly described below. Referring to FIG. 7, the integrated circuit device 100e may have a configuration substantially similar to the configuration of the integrated circuit device 100 of FIGS. 1 and 2, except that the adhesive layer 164 is omitted. In this case, the outer sidewall of the gate line 166 may be in contact with the inner sidewall of the dielectric layer 162.

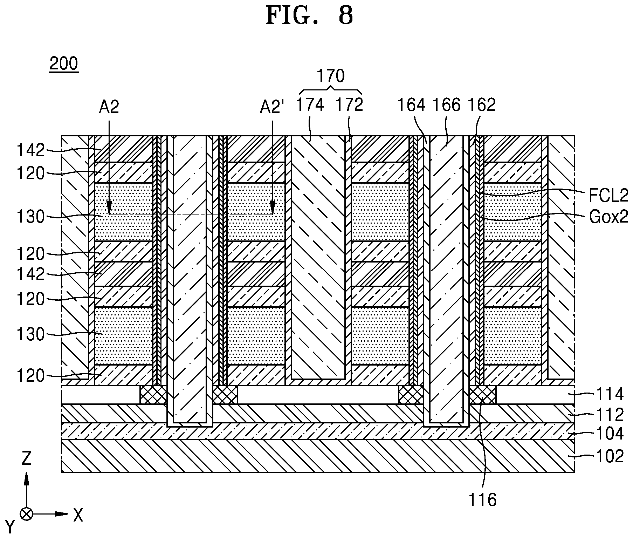

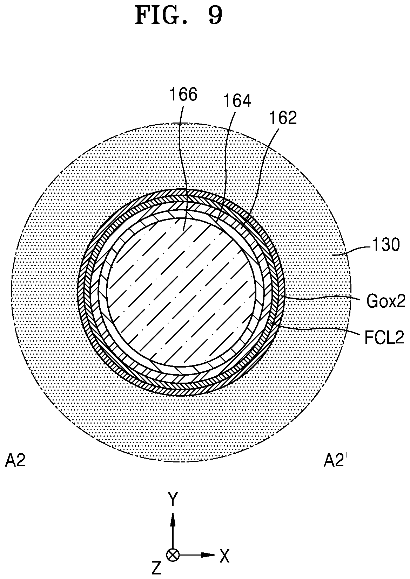

FIG. 8 is a cross-sectional view of an integrated circuit device 200 according to embodiments. FIG. 9 is a plan view taken along line A2-A2' in FIG. 8. The elements of the integrated circuit device 200 of FIGS. 8 and 9 are similar to those of the integrated circuit device 100 described with reference to FIGS. 1 and 2, and thus, the differences between the integrated circuit devices 200 and 100 are mainly described below. Referring to FIGS. 8 and 9, the integrated circuit device 200 may include a plurality of gate lines 166 extending lengthwise in the vertical direction (the Z direction) on the substrate 102, an adhesive layer 164 surrounding the sidewall and bottom surface of each of the gate lines 166, a dielectric layer 162 surrounding at least a portion of the sidewall of the adhesive layer 164, a fixed charge layer FCL2 surrounding the sidewall of the dielectric layer 162, and a gate dielectric layer Gox2 surrounding the sidewall of the fixed charge layer FCL2. In other words, the integrated circuit device 200 may not include the metal layer 150 included in the integrated circuit device 100 of FIGS. 1 and 2.

In embodiments, the dielectric layer 162 may include an antiferroelectric material. For example, the antiferroelectric material may include at least one selected from the group consisting of hafnium, zirconium, silicon, yttrium, aluminum, gadolinium, strontium, lanthanum, titanium, scandium, and oxides thereof.

The fixed charge layer FCL2 may surround each gate line 166 and the sidewall of the dielectric layer 162. The fixed charge layer FCL2 may extend in the vertical direction (the Z direction) on the sidewall of the dielectric layer 162. The top surface of the fixed charge layer FCL2 may be at the same vertical level as the top surface of the dielectric layer 162. The bottom surface of the fixed charge layer FCL2 may be at the same vertical level as the bottom surface of the dielectric layer 162. The bottom surface of the fixed charge layer FCL2 may be in contact with the top surface of the etch stop film 116. The fixed charge layer FCL2 may have a positive or negative charge density. In embodiments, the fixed charge layer FCL2 may be doped with dopant particles. For example, the dopant particles may include at least one selected from the group consisting of Al, P, Ca, Sc, V, Cr, Sr, Y, Nb, Mo, Tm, Yb, Lu, Ta, and W. In some embodiments, the fixed charge layer FCL2 may include an oxygen vacancy.

The hysteresis curve of the dielectric layer 162 including an antiferroelectric material may shift to the left or the right on the voltage axis due to the presence of the fixed charge layer FCL2, which has the positive or negative charge density. As the hysteresis curve of the dielectric layer 162 including an antiferroelectric material shifts to the left or the right on the voltage axis, the dielectric layer 162 including the antiferroelectric material may have a non-zero polarization value even at a voltage of 0. Accordingly, the dielectric layer 162 including an antiferroelectric material may operate in the same manner as the dielectric layer 162 including a ferroelectric material having a non-zero polarization value even at a voltage of 0.

The gate dielectric layer Gox2 may surround the gate line 166 and the sidewall of the fixed charge layer FCL2. The gate dielectric layer Gox2 may extend in the vertical direction (the Z direction) on the sidewall of the fixed charge layer FCL2. The top surface of the gate dielectric layer Gox2 may be at the same vertical level as the top surface of the fixed charge layer FCL2. The bottom surface of the gate dielectric layer Gox2 may be at the same vertical level as the bottom surface of the fixed charge layer FCL2. The outer sidewall of the gate dielectric layer Gox2 may be in contact with the channel layer 130 and the conductive layer 120. The bottom surface of the gate dielectric layer Gox2 may be in contact with the top surface of the etch stop film 116.

For example, the gate dielectric layer Gox2 may include silicon oxide, silicon nitride, silicon oxynitride, or a combination thereof. In some embodiments, the gate dielectric layer Gox2 may include a high-k dielectric material, which may be relative to silicon oxide. The high-k dielectric material may have a dielectric constant of about 10 to about 25. For example, the high-k dielectric material may include, but not limited to, hafnium oxide, aluminum oxide, zirconium oxide, or a combination thereof.

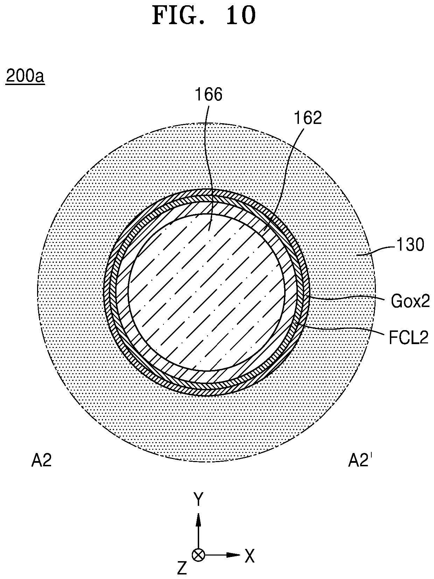

FIG. 10 is a plan view illustrating a partial configuration of an integrated circuit device 200a, taken along a line corresponding to line A2-A2' in FIG. 8, according to embodiments. The elements of the integrated circuit device 200a of FIG. 10 are similar to those of the integrated circuit device 200 described with reference to FIGS. 8 and 9, and thus, the differences between the integrated circuit devices 200a and 200 are mainly described below. Referring to FIG. 10, the integrated circuit device 200a may have a configuration substantially similar to the configuration of the integrated circuit device 200 of FIGS. 8 and 9, except that the adhesive layer 164 is omitted. In this case, the outer sidewall of the gate line 166 may be in contact with the inner sidewall of the dielectric layer 162.

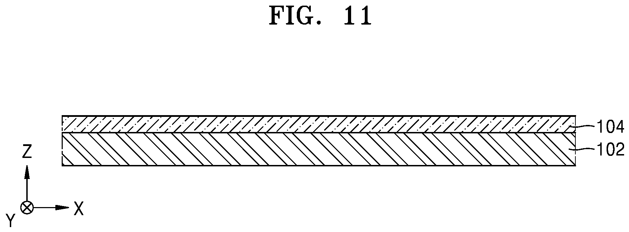

FIGS. 11 to 24 are cross-sectional views illustrating a method of manufacturing the integrated circuit device 100, according to embodiments. Referring to FIG. 11, the global gate line 104 may be formed on the substrate 102. For example, the global gate line 104 may be formed by a vapor deposition process. For example, the global gate line 104 may include at least one selected from the group consisting of a doped semiconductor material, conductive metal nitride, metal, and a metal-semiconductor compound.

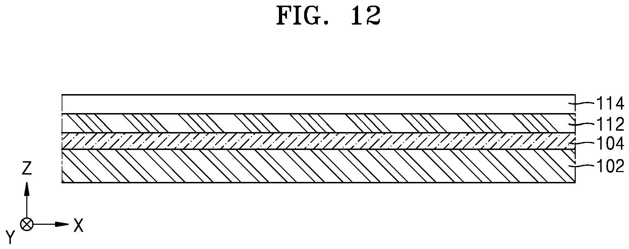

Referring to FIG. 12, a first insulating layer 112 and a second insulating layer 114 may be sequentially stacked on the global gate line 104 in the resultant structure of FIG. 11. For example, each of the first insulating layer 112 and the second insulating layer 114 may be formed by a vapor deposition process. For example, each of the first insulating layer 112 and the second insulating layer 114 may include nitride, oxide, or a combination thereof.

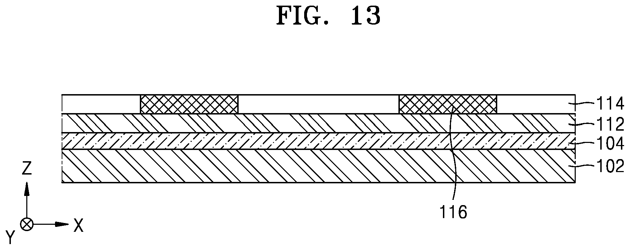

Referring to FIG. 13, the second insulating layer 114 may be patterned in the resultant structure of FIG. 12, and an etch stop film 116 may be formed to fill a patterned space in the second insulating layer 114. For example, the etch stop film 116 may include silicon carbide (SiC), silicon nitride (SiN), nitrogen-doped silicon carbide (SiC:N), SiOC, AIN, AlON, AlO, AlOC, or a combination thereof.

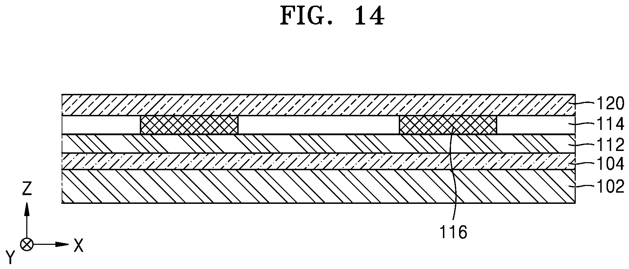

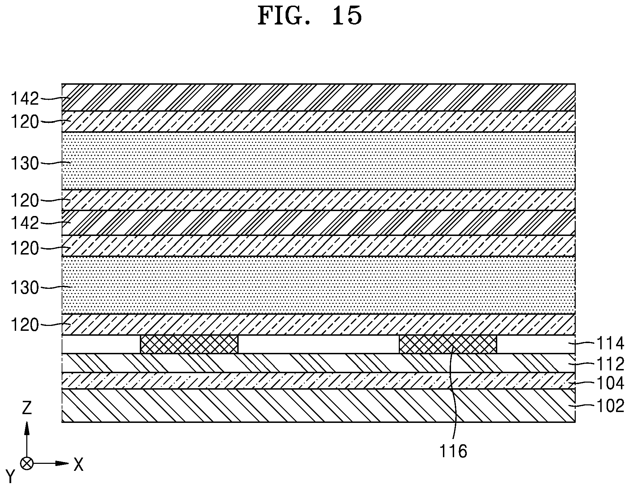

Referring to FIGS. 14 and 15, a conductive layer 120, a channel layer 130, another conductive layer 120, and an interlayer insulating layer 142 may be formed on the second insulating layer 114 and the etch stop film 116 in the resultant structure of FIG. 13. For example, the conductive layers 120, the channel layer 130, and the interlayer insulating layer 142 may be formed by a vapor deposition process.

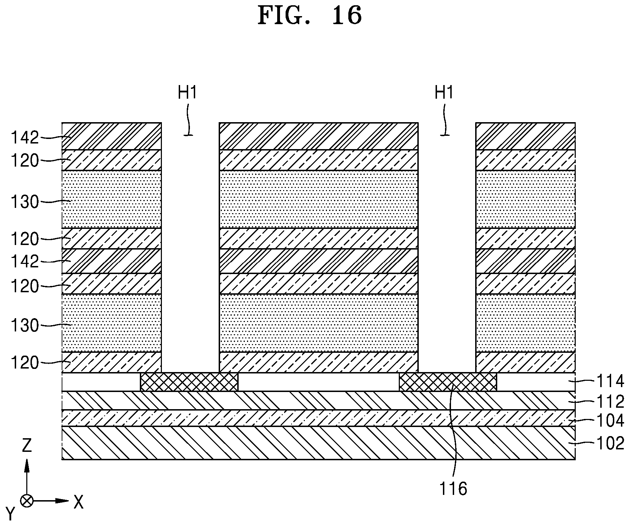

Referring to FIG. 16, a first hole H1 passing through the conductive layer 120, the channel layer 130, the conductive layer 120, and the interlayer insulating layer 142, which are stacked on the second insulating layer 114 and the etch stop film 116, may be formed in the resultant structure of FIG. 15. The first hole H1 may extend in the vertical direction (the Z direction) through the conductive layer 120, the channel layer 130, the conductive layer 120, and the interlayer insulating layer 142 and may expose the top surface of the etch stop film 116.

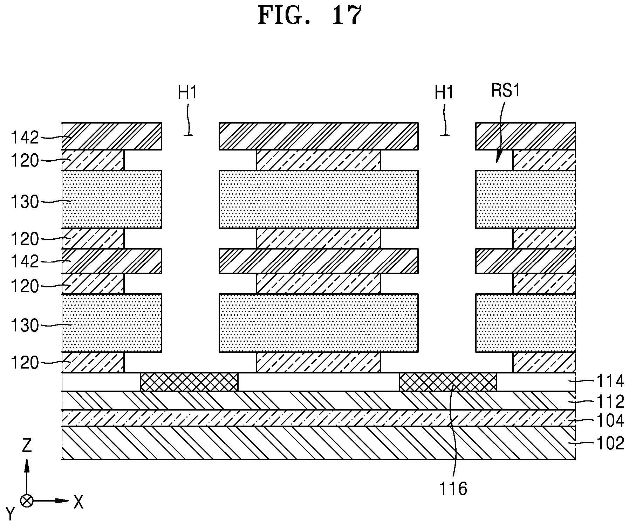

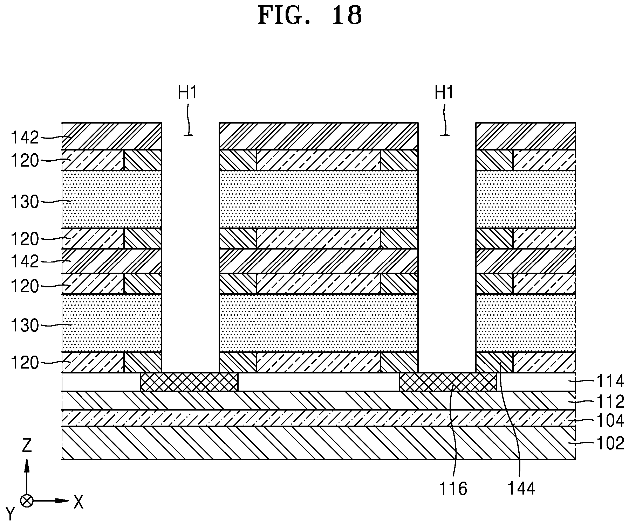

Referring to FIG. 17, a portion of each of the conductive layers 120 may be removed from the exposed sidewall of each conductive layer 120 in the resultant structure of FIG. 16 such that a first recess RS1 in which the portion of the conductive layer 120 is horizontally recessed may be formed. The first recess RS1 may communicate with the first hole H1. The first recess RS1 may be formed by an etching process. For example, the etching process may be performed using an etchant having an etch selectivity with respect to the conductive layer 120. Referring to FIG. 18, a buried insulating layer 144 may be formed to fill the first recess RS1 in the resultant structure of FIG. 17. For example, the buried insulating layer 144 may include silicon nitride, silicon oxide, or a combination thereof.

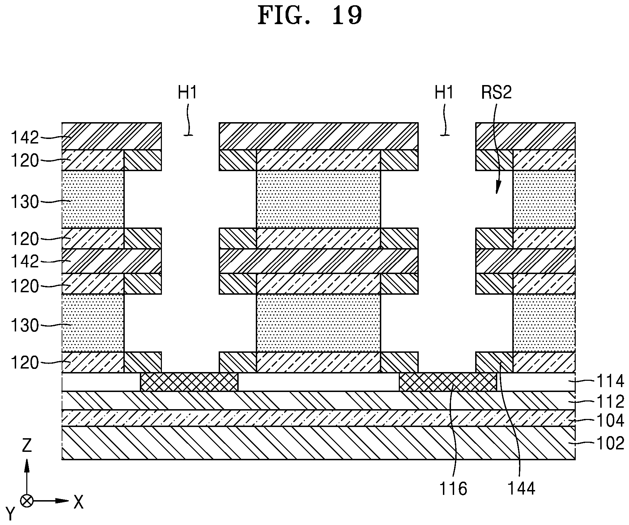

Referring to FIG. 19, a portion of the channel layer 130 may be removed from the exposed sidewall of the channel layer 130 in the resultant structure of FIG. 18 such that a second recess RS2 in which the portion of the channel layer 130 is horizontally recessed may be formed. The second recess RS2 may communicate with the first hole H1. The second recess RS2 may be formed by an etching process. For example, the etching process may be performed using an etchant having an etch selectivity with respect to the channel layer 130.

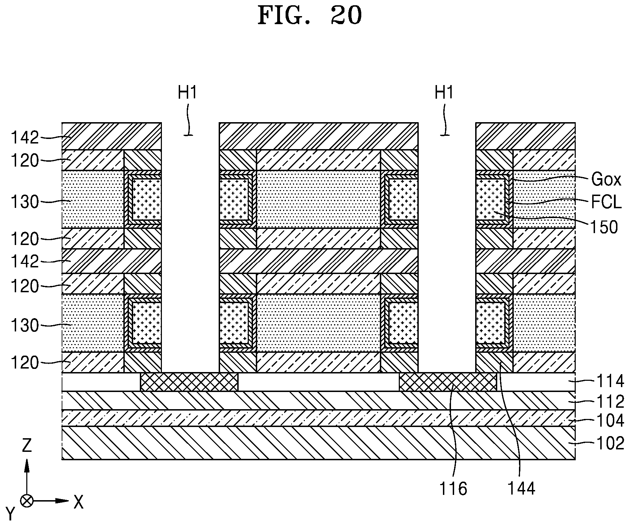

Referring to FIG. 20, a gate dielectric layer Gox, a fixed charge layer FCL, and a metal layer 150 may be sequentially formed to fill the second recess RS2 in the resultant structure of FIG. 19. The gate dielectric layer Gox may cover a sidewall of the channel layer 130. The fixed charge layer FCL may cover the inner wall of the gate dielectric layer Gox. The metal layer 150 may cover the inner wall of the fixed charge layer FCL.

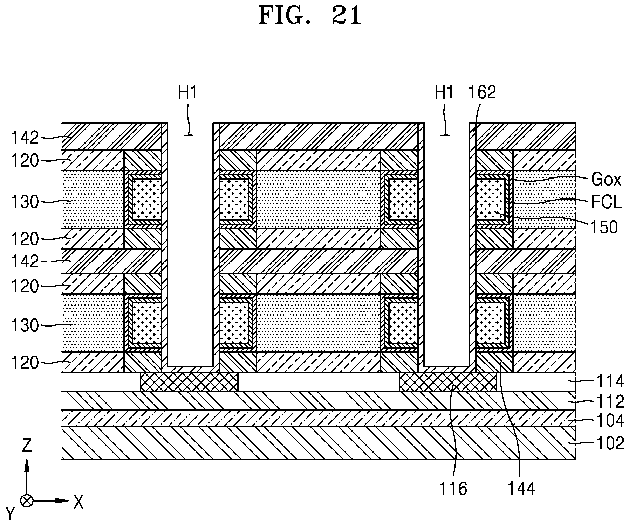

Referring to FIG. 21, a dielectric layer 162 covering the inner wall and bottom surface of the first hole H1 may be formed in the resultant structure of FIG. 20. The bottom surface of the dielectric layer 162 may be in contact with the etch stop film 116. For example, the dielectric layer 162 may include an antiferroelectric material. In some embodiments, the dielectric layer 162 may include a ferroelectric material.

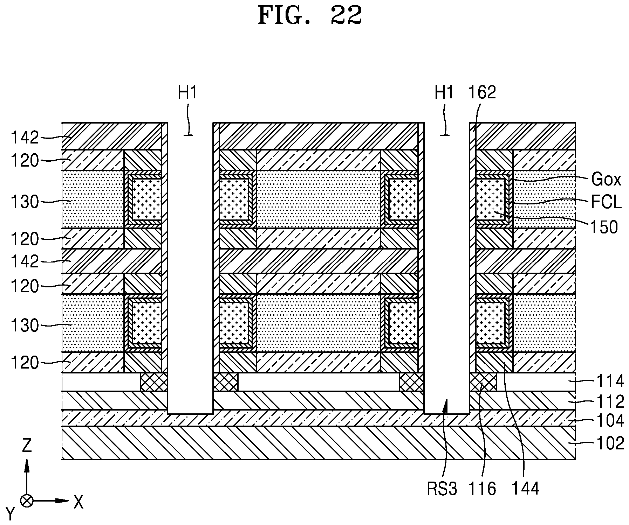

Referring to FIG. 22, a third recess RS3 passing through the dielectric layer 162 covering the bottom surface of the first hole H1, the etch stop film 116, and the first insulating layer 112 in the vertical direction (the Z direction) may be formed through the first hole H1 in the resultant structure of FIG. 21. The third recess RS3 may extend into the global gate line 104. The third recess RS3 may communicate with the first hole H1.

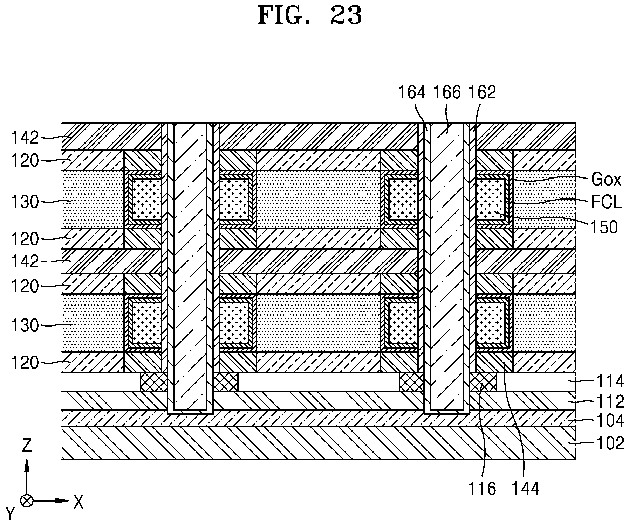

Referring to FIG. 23, an adhesive layer 164 and a gate line 166 may be sequentially formed to fill the first hole H1 and the third recess RS3 in the resultant structure of FIG. 22. The adhesive layer 164 may cover the inner wall and bottom surface of each of the first hole H1 (see FIG. 22) and the third recess RS3 (see FIG. 23). The gate line 166 may fill an empty space in the first hole H1 (see FIG. 22) and the third recess RS3 (see FIG. 23). The bottom surface of the adhesive layer 164 may be in contact with the global gate line 104.

Referring to FIG. 24, a second hole H2 passing through the conductive layer 120, the channel layer 130, the conductive layer 120, and the interlayer insulating layer 142, which are stacked on the second insulating layer 114, may be formed between gate lines 166 horizontally spaced apart from each other in the resultant structure of FIG. 23. The second hole H2 may extend in the vertical direction (the Z direction) through the conductive layer 120, the channel layer 130, the conductive layer 120, and the interlayer insulating layer 142 and may expose a portion of the top surface of the first insulating layer 112.

The integrated circuit device 100 of FIGS. 1 and 2 may be manufactured by forming the intercell insulating structure 170 (see FIG. 1) including the insulating liner 172 and the intercell insulating film 174, which sequentially fill the second hole H2 in the resultant structure of FIG. 24.

While the inventive concept has been particularly shown and described with reference to embodiments thereof, it will be understood that various changes in form and details may be made therein without departing from the scope of the following claims.

## Claims

1. An integrated circuit device, comprising:
a gate line extending in a vertical direction on a substrate;
a dielectric layer surrounding the gate line and extending in the vertical direction;
at least one metal layer surrounding the gate line;
at least one fixed charge layer surrounding the gate line; and
at least one gate dielectric layer surrounding the gate line.

2. The device of Claim 1, wherein the at least one fixed charge layer includes one of aluminum oxide, hafnium oxide, tantalum oxide, titanium oxide, silicon nitride, and combinations thereof.

3. The device of Claim 1 or Claim 2, wherein the dielectric layer includes an antiferroelectric material.

4. The device of any of Claims 1-3, wherein the dielectric layer includes a ferroelectric material.

5. The device of any preceding Claim, wherein the at least one metal layer includes a plurality of metal layers, the at least one fixed charge layer includes a plurality of fixed charge layers, the plurality of metal layers are spaced apart from each other in the vertical direction and surround the gate line, and the plurality of fixed charge layers are spaced apart from each other in the vertical direction and surround the gate line.

6. The device of any preceding Claim, wherein the at least one metal layer surrounds an outer sidewall of the dielectric layer, the at least one fixed charge layer surrounds an outer sidewall of the at least one metal layer, and the at least one gate dielectric layer surrounds an outer sidewall of the at least one fixed charge layer.

7. The device of any of Claims 1-5, wherein the at least one metal layer surrounds an outer sidewall of the dielectric layer, the at least one gate dielectric layer surrounds an outer sidewall of the at least one metal layer, and the at least one fixed charge layer surrounds an outer sidewall of the at least one gate dielectric layer.

8. The device of any preceding Claim, wherein the at least one gate dielectric layer includes one of aluminum oxide, hafnium oxide, tantalum oxide, titanium oxide, silicon nitride, and combinations thereof.

9. The device of any of Claims 1-5, or Claim 8 when dependent on any of Claims 1-5, wherein the at least one fixed charge layer surrounds an outer sidewall of the dielectric layer, the at least one metal layer surrounds an outer sidewall of the at least one fixed charge layer, and the at least one gate dielectric layer surrounds an outer sidewall of the at least one metal layer.

10. The device of any of Claims 1-5, or Claim 8 when dependent on any of Claims 1-5, wherein the at least one fixed charge layer is between the gate line and the dielectric layer.

11. An integrated circuit device, comprising:
a gate line extending in a vertical direction on a substrate;
a dielectric layer including an antiferroelectric material, which surrounds the gate line and extends in the vertical direction;
a fixed charge layer surrounding the gate line and extending in the vertical direction; and
a gate dielectric layer surrounding the gate line and extending in the vertical direction.

12. The device of Claim 11, wherein the fixed charge layer includes one of aluminum oxide, hafnium oxide, tantalum oxide, titanium oxide, silicon nitride, and combinations thereof.

13. The device of Claim 11 or Claim 12, wherein the dielectric layer extends in the vertical direction along a sidewall of the gate line, the fixed charge layer extends in the vertical direction along a sidewall of the dielectric layer, and the gate dielectric layer extends in the vertical direction along a sidewall of the fixed charge layer.

14. The device of any of Claims 11-13, wherein a bottom surface of the dielectric layer, a bottom surface of the fixed charge layer, and a bottom surface of the gate dielectric layer are at a same vertical level.

15. The device of any of Claims 11-14, further comprising:
a channel layer surrounding the gate line and conductive layers separated from each other by the channel layer in the vertical direction; and
wherein an outer sidewall of the gate dielectric layer is in contact with the channel layer and the conductive layers.
